# EUROPÄISCHE PATENTANMELDUNG

(11) **EP 4 592 429 A1**
(43) Veröffentlichungstag der Anmeldung: **30.07.2025**
(21) Anmeldenummer: 24153424.7
(22) Anmeldetag: 23.01.2024
(51) Int. Cl.: C30B 25/10, C23C 16/48, C30B 25/16, C30B 29/06

(54) **VERFAHREN ZUM EPITAKTISCHEN BESCHICHTEN VON HALBLEITERSCHEIBEN**

(71) Anmelder: Siltronic AG, 81677 München (DE); Siltronic Silicon Wafer Pte. Ltd., Singapore 528759 (SG)
(72) Erfinder: Haberecht, Jörg, 09599 Freiberg (DE); Stein, Rene, 09627 Bobritzsch-Hilbersdorf (DE); Loh, Yew Hui, 528759 Singapore (SG)
(74) Vertreter: Hasenhütl, Eva

(57) **Zusammenfassung**

Verfahren zum Abscheiden einer epitaktischen Schicht auf einer Vorderseite von Substraten, umfassend das Erhitzen eines ersten Substrats auf eine Abscheidetemperatur mittels einer ersten Wärmequelle mittels Wärmestrahlung, die zu der Vorderseite des ersten Substrats gerichtet ist, das Erhöhen der Abscheidetemperatur auf Teilbereichen der Vorderseite des ersten Substrats unter Verwendung eines ersten Intensitätsprofils, das die Intensität der Wärmestrahlung aus einer zweiten Wärmequelle als Funktion des Ortes auf der Vorderseite des Substrates beschreibt, das Abscheiden einer epitaktischen Schicht auf der Vorderseite des ersten Substrats, wobei Abscheidegas über die Vorderseite geleitet wird, und das Abscheiden einer epitaktischen Schicht auf einer Vorderseite eines zweiten Substrates unter Verwendung eines zweiten Intensitätsprofils, dadurch gekennzeichnet, dass sich das erste Intensitätsprofil vom zweiten Intensitätsprofil unterscheidet.

## Beschreibung

Gegenstand der Erfindung ist ein Verfahren zum Abscheiden einer epitaktischen Schicht auf der Vorderseite eines Substrates aus einkristallinem Material.

### Stand der Technik / Probleme

Das Abscheiden einer epitaktischen Schicht auf der Vorderseite einer Halbleiterscheibe geschieht üblicherweise mittels CVD (chemical vapor deposition) in einem CVD-Reaktor, häufig in einem Einzelscheiben-Reaktor. Beispielsweise sei die US 2014/0 251 208 A1 erwähnt, in der ein solcher CVD-Reaktor beschrieben ist. Ein Einzelscheiben-Reaktor stellt zwischen einem oberen und einem unteren Deckel (dome) einen Reaktionsraum bereit, in dem ein Suszeptor von Suszeptor-Tragarmen einer Suszeptor-Tragwelle auf Suszeptor-Stützstiften gehalten wird. Der Suszeptor und eine darauf abgelegte Halbleiterscheibe wird durch Lampenreihen (arrays), die über und unter den Deckeln angeordnet sind, mittels Wärmestrahlung erhitzt, während ein Abscheidegas über die, zum oberen Deckel weisende Vorderseite der Halbleiterscheibe geleitet wird.

Die Gleichmäßigkeit der Schichtdicke der epitaktischen Schicht ist eines der wichtigsten Qualitätsmerkmale des epitaktischen Wafers und wird im Allgemeinen durch eine optische Messmethode unter Verwendung von Infrarotlicht bewertet. Außerdem wird die Gleichmäßigkeit der Schichtdicke (Ebenheit) des gesamten epitaktischen Wafers durch eine Technik bewertet, die eine elektrische Kapazität oder einen optischen Verschiebungsmesser als grundlegendes Prinzip verwendet.

Bei der auf diesen Methoden basierenden Formmessung kann jedoch eine äußere Randform, die weiter als 3 mm von der Kante eines Wafers entfernt ist, aufgrund der prinzipiellen Beschränkungen und der Struktur eines Geräts nicht genau gemessen werden. Daher konzentriert sich die Diskussion über die Gleichmäßigkeit der Dicke der Epitaxieschicht hauptsächlich auf den Bereich innerhalb der Kante von mehr als 5 mm, und die Gleichmäßigkeit der Schichtdicke in der Nähe der äußersten Peripherie nahe der Kante des Wafers hat eine untergeordnete Beachtung gefunden. Unter dem Gesichtspunkt der Miniaturisierung eines Halbleiterbauelements oder der Ausweitung des Herstellungsbereichs der Bauelemente wurde in den letzten Jahren jedoch ein hoher Ebenheitsgrad in der Nähe des äußersten Umfangs eines Wafers gefordert. Daher legt sich nun das Hauptaugenmerk vermehrt auf diesen Bereich.

Darüber hinaus wurde ein Gerät entwickelt, das die Oberflächenform eines Wafers in der Nähe des äußersten Umfangs misst und einen Index, der als Kantenabrollung (edge roll off) bezeichnet wird, der quantitativ einen Durchbiegungsgrad und einen Anstiegsgrad des äußersten Umfangsbereichs eines Wafers anzeigt.

In den letzten Jahren hat sich die Forderung nach einer Standardisierung des Roll-Offs auf einen epitaktischen Wafer ausgeweitet, und es wird eine Kontrolle der äußeren Umfangsformen einer epitaktischen Schicht und eines epitaktischen Wafers gewünscht. Bei einer konventionellen Epitaxie-Technologie kann jedoch die Dicke einer Epitaxieschicht in einigen Fällen in der Nähe des äußersten Randes reduziert werden und es besteht das Problem, dass der Roll-Off durch einen Epitaxie-Prozess im Vergleich zu dem eines Siliziumwafers vor dem Epitaxie-Wachstum verschlechtert wird.

Als Verfahren zur Herstellung eines epitaktischen Wafers mit einem hohen Ebenheitsgrad auch in der Nähe der äußersten Peripherie wurde zum Beispiel in JP 2003-332183 A ein Verfahren vorgeschlagen, bei dem ein Schleifstein verwendet wird, um den Durchmesser des Wafers zu verringern, oder bei dem ein Laser verwendet wird, um ein Schmelzschneiden in Bezug auf einen peripheren Teil nach dem epitaktischen Wachstum durchzuführen.

Diese Methode birgt jedoch das Problem, dass durch die Durchmesserreduzierung oder das Schmelzschneiden nach dem Epitaxiewachstum möglicherweise Partikel entstehen oder Risse entstehen können und der Wafer klein wird, weil er nach dem Epitaxiewachstum einer Durchmesserreduzierung oder einem Schmelzschneiden unterzogen wird, wodurch die Produktivität oder das Ausbeuteverhältnis erheblich beeinträchtigt wird.

In der US 2007/0227441 A1 wird auf periodische Schwankungen der Dicke im Randbereich von epitaktisch beschichteten Halbleiterscheiben aus Silizium hingewiesen. Grund sind unterschiedliche Wachstumsgeschwindigkeiten, mit denen die epitaktische Schicht wächst. Die unterschiedlichen Wachstumsgeschwindigkeiten stehen in einem Zusammenhang mit der Kristallorientierung der Vorderseite der Halbleiterscheibe. Die Vorderseite der Halbleiterscheibe ist diejenige Seitenfläche der Halbleiterscheibe, auf der die epitaktische Schicht abgeschieden wird. Um die Dicke der epitaktischen Schicht im Randbereich zu vergleichmäßigen, wird in US 2007/0227441 A1 vorgeschlagen, die Struktur des Suszeptors mit der Periode der Dickenschwankungen zu verändern.

Die genannten Vorschläge erfordern eine Modifikation des verwendeten Suszeptors oder der Form des Randbereichs der Halbleiterscheibe.

Werden viele Halbleiterscheiben nacheinander mit einer epitaktischen Schicht versehen, verändern sich auch die Wachstumsbedingungen in der Kammer zum Beispiel wegen einer zunehmenden parasitären Abscheidung von Silicium auf der Oberfläche der Kammer, was wiederum zu unterschiedlichen thermischen Bedingungen führt, die eine veränderte Geometrie auf der Oberfläche der Halbleiterscheiben hervorrufen. Der Stand der Technik bietet zwar Möglichkeiten, diesen Effekt zu reduzieren, etwa durch zwischenzeitliches Ätzen der Abscheidekammer, lokale Auswirkungen zu verhindern vermag er aber nicht.

Aufgabe der vorliegenden Erfindung ist es, die Ebenheit von Halbleiterscheiben mit abgeschiedener epitaktischer Schicht zu verbessern, ohne dafür den Suszeptor oder die Form des Randbereichs der Halbleiterscheibe verändern zu müssen.

Die Aufgabe wird gelöst durch die in den Ansprüchen beschriebenen Verfahren.

### Kurzbeschreibung der Figuren

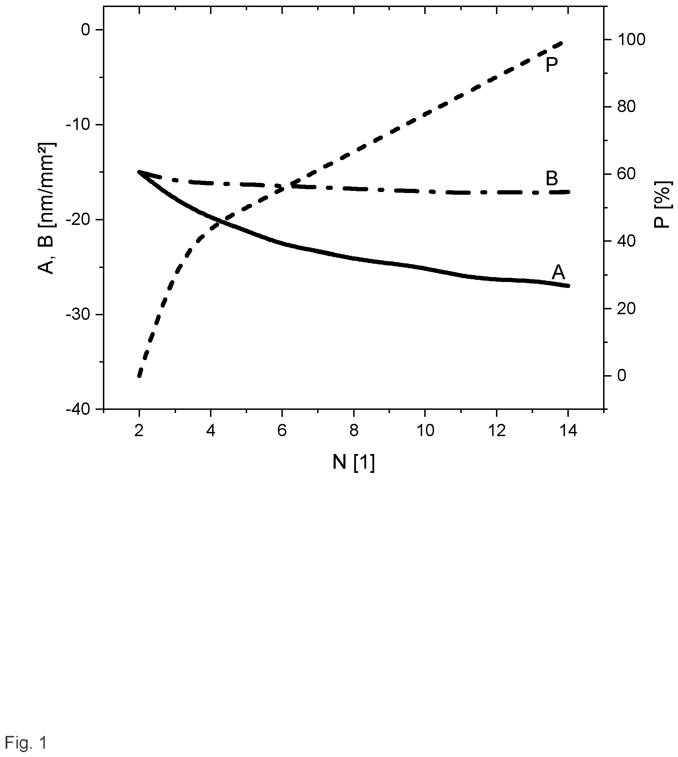

**Fig. 1** zeigt zum einen die ZDD-Werte in der Ordinate als Funktion der durchgeführten Abscheidungen nach einem erfolgten Ätzschritt der Kammer N (Abszisse). "A" bezeichnet dabei die ZDD-Werte, die nach dem Stand der Technik ermittelt wurden und "B" die ZDD-Werte, die unter Verwendung, des erfindungsgemäßen Verfahrens erreicht wurden.

Der Parameter "P" gibt die Leistung der zweiten Wärmequelle in relativen Einheiten wieder, die verwendet wurde, um die ZDD-Werte aus der Messreihe "B" zu erreichen.

### Detaillierte Beschreibung der Erfindung

Die Erfindung beruht auf der Beobachtung, dass sich die jeweilige Geometrie einer auf einem Substrat abgeschiedenen epitaktischen Schicht von Substrat zu Substrat unterscheidet.

Beispielsweise bilden sich zunehmend parasitäre Beschichtungen auf der Oberfläche der Abscheidekammer, die wiederum zu unterschiedlichen Abscheidebedingungen und damit zu einer veränderten Geometrie auf der Oberfläche der Halbleiterscheiben führen.

Der Stand der Technik bietet Möglichkeiten, diesen Effekt etwas zu reduzieren, etwa durch zwischenzeitliches Ätzen der Abscheidekammer, um so die Abscheidebedingungen zu vergleichmäßigen. Diese Verfahren sind aber nur bedingt geeignet, die Problematik zu lösen und weitere Verbesserungen sind daher nötig.

Die Erfinder haben erkannt, dass eine parasitäre Beschichtung des Suszeptors nahe des Randes des Substrates ("Pocket") sich besonders nachteilig auf die Beschichtung in der Nähe des Randes des Substrats auswirkt.

Dieser Effekt kann numerisch ermittelt werden, wenn zum Beispiel der Parameter ZDD (nach SEMI M68 - Test Method for Determining Wafer Near-Edge Geometry from a Measured Height Data Array Using a Curvature Metric, ZDD) gemessen wird.

**Fig. 1** zeigt ZDD-Werte (**A**) als Funktion der durchgeführten Abscheidungen nach einem erfolgten Ätzschritt der Kammer (**N**) gemäß Stand der Technik. Deutlich ist zu erkennen, dass sich der Wert mit zunehmender Anzahl der durchgeführten Abscheidungen **N** verringert. Diese Verringerung stellt eine ungewollte Veränderung des Abscheideprozesses dar, die die Erfinder mit geeigneten Maßnahmen reduzieren wollten.

Notwendig für die Erfindung ist das Erhitzen eines ersten Substrats auf eine Abscheidetemperatur mittels einer ersten Wärmequelle mittels Wärmestrahlung, die zu der Vorderseite des ersten Substrats gerichtet ist. In der Regel ist wird dabei die Temperatur so geregelt, dass sie in der Mitte des Substrates gemessen wird und Abweichungen der Temperatur von einer gewünschten Temperatur durch kleine Leistungsänderungen der ersten Wärmequelle geregelt wird.

Die Erfinder haben dabei erkannt, dass sich mit diesen kleinen Leistungsänderungen zwar eine Temperatur in der Mitte der Substrate gut einstellen lässt, jedoch trifft dies nicht für alle Bereiche des Substrates gleichermaßen zu, insbesondere, je weiter entfernt sich diese Bereiche von der Messposition der Temperatur befinden.

Notwendig für die Erfindung ist zusätzlich das Erhöhen der Abscheidetemperatur auf Teilbereichen der Vorderseite des ersten Substrats unter Verwendung eines ersten Intensitätsprofils, das die Intensität der Wärmestrahlung aus einer zweiten Wärmequelle als Funktion des Ortes auf der Vorderseite des Substrates beschreibt.

Besonders erwähnenswert ist hierbei, dass die Substratscheibe während des Beschichtens rotiert und damit auch die Teilbereiche, die mit der zweiten Wärmequelle weiter erhitzt werden sollen.

Bei der Beschichtung enthält die zweite Wärmequelle dabei bevorzugt eine Lichtquelle, die Licht im infraroten Spektralbereich auf die Vorderseite des Substrats gerichtet aussenden kann. Besonders geeignet ist hierbei die Verwendung eines Lasers, der Licht im infraroten Lichtspektrum ausstrahlt. Die die zweite Wärmequelle ist dabei so angeordnet, dass die Wirkung auf feste Orte auf dem Substrat begrenzt werden kann, ob wohl das Substrat dabei rotiert.

Ein Effekt der Verwendung dieser zweite Wärmequelle ist, dass die Temperatur der Oberfläche des Substrates gezielt und unabhängig von der ersten Wärmequelle korrigiert (erhöht) werden kann. Ein zweiter Effekt liegt darin, dass dieser Bereich mit dem Substrat rotieren kann. So kann beispielsweise bei einer Halbleiterscheibe, die als Substrat für die Beschichtung dient und eine Orientierungsmarkierung ("Notch") aufweist, die Temperatur in einem Bereich um die Orientierungsmarkierung herum sehr genau korrigiert werden, obwohl die Halbleiterscheibe sich während der Beschichtung dreht.

Die zweite Wärmequelle projiziert dabei ein definiertes Intensitätsprofil auf einen gewünschten Ort auf einer Seite des Substrats und erhöht damit die Temperatur an diesem Ort. Je höher die Intensität, umso höher fällt dabei die Korrektur der Temperatur aus. Der Begriff "Intensitätsprofil" wird dabei als Intensität auf dem Substrat als Funktion des Ortes auf dem Substrat verstanden.

Die Erfinder haben erkannt, dass die Einstellung des Intensitätsprofils positive Auswirkung auf die Geometrie der abgeschiedenen Schicht auf dem Substrat haben kann. Sie haben dabei auch erkannt, dass es notwendig ist, dieses Intensitätsprofil als Funktion der Anzahl der abgeschiedenen Schichten anzupassen, da offenbar parasitäre Abscheidungen in der Kammer die Eigenschaften der Kammer und damit die Temperatur an manchen Bereichen des Substrates verändern.

Die Anzahl der abgeschiedenen Schichten wird dabei als Anzahl der Abscheidungen verstanden, wobei es unerheblich ist, ob mehrere Substrate mit beispielsweise einer Schicht versehen werden oder ein Substrat mit mehreren unterscheidbaren Schichten.

Die Erfinder haben erkannt, dass es notwendig für die Erfindung ist, das Intensitätsprofil von Abscheidung zu Abscheidung anzupassen und so ein erstes Intensitätsprofil bei einer ersten Abscheidung zu verwenden und bei einer später durchgeführten zweitem Abscheidung ein zweites Intensitätsprofil zu verwenden, das sich vom ersten Intensitätsprofil unterscheidet.

Ein Intensitätsprofil kann ermittelt werden, indem zum Beispiel die Schichtdicke der Schicht gemessen wird und die Intensität so eingestellt wird, dass die Schichtdicke dem gewünschten Wert entspricht. Insbesondere kann die Intensitätsverteilung so eingestellt werden, dass die lokale Schichtdickenvariation minimal ist. Dem Fachmann sind hier viele Möglichkeiten bekannt, wie dies Schichtdicke gemessen werden kann.

An Orten, an denen die Schichtdicke dünner ist, wird dabei die Intensität im Intensitätsprofil erhöht. Diese Korrektur kann so für jedes Substrat durchgeführt werden.

Wird die Kammer -wie im Stand der Technik beschrieben- freigeätzt, werden alle Abscheidungen, die sich durch die vorangegangenen Abscheidungen an den inneren Flächen und Wänden der Kammer abgesetzt haben, entfernt. Nach jedem Freiätzen wird also die Kammer auf Anfangsbedingungen -was die Abscheidungen betrifftzurückgesetzt. Das heißt auch, dass alle Abscheidungen, die nach einem Freiätzen durchgeführt werden, ähnliche Eigenschaften aufweisen, die die entsprechenden Abscheidungen nach einem nächsten Freiätzen.

Die Erfinder haben erkannt, dass auf diese Weise ein zeitlich abhängiges Intensitätsprofil ermittelt werden kann, das die Folgen einer parasitären Abscheidung in der Kammer auf das zu beschichtende Substrat kompensiert.

In Fig. 1 ist schematisch gezeigt, wie sich die Geometrie einer Halbleiterscheibe -hier repräsentiert durch den ZDD-Wert- positiv beeinflussen lässt, wenn eine zusätzliche Wärmequelle eine lokale Erwärmung verursacht.

Das Verfahren zeigt im Wesentlichen zwei Vorteile auf: (a) die Abscheidungen, die zwischen dem Freiätzen durchgeführt werden, ergeben eine bessere homogene Schichtdicke und (b) die Anzahl der Abscheidungen, die zwischen zwei Freiätzungen durchgeführt wird kann erhöht werden, ohne dabei Qualitätseinbußen erleiden zu müssen, bei gleichzeitiger Durchsatzerhöhung, da während des Abätzens die Kammer nicht für Abscheidung zur Verfügung steht.

Das erfindungsgemäße Verfahren umfasst also folgende Schritte:
(a) Das Erhitzen eines ersten Substrats auf eine Abscheidetemperatur mittels einer ersten Wärmequelle mittels Wärmestrahlung, die zu der Vorderseite des ersten Substrats gerichtet ist;
   Bevorzugt besteht das Substrat aus monokristallinem Silicium und besonders bevorzugt weist das Substrat eine Kristallorientierung <110> auf.
(b) das Erhöhen der Abscheidetemperatur auf Teilbereichen der Vorderseite des ersten Substrats unter Verwendung eines ersten Intensitätsprofils, das die Intensität der Wärmestrahlung aus einer zweiten Wärmequelle als Funktion des Ortes auf der Vorderseite des Substrates beschreibt;
   Bevorzugt enthält die zweite Wärmequelle eine Lichtquelle, die Licht im infraroten Spektralbereich auf die Vorderseite gerichtet aussenden kann.
(c) das Abscheiden einer epitaktischen Schicht auf der Vorderseite des ersten Substrats, wobei Abscheidegas über die Vorderseite geleitet wird, und das Abscheiden einer epitaktischen Schicht auf einer Vorderseite eines zweiten Substrates unter Verwendung eines zweiten Intensitätsprofils, wobei sich das erste Intensitätsprofil vom zweiten Intensitätsprofil unterscheidet.

Bevorzugt beträgt der Durchmesser des Substrats 300 mm und der minimale Abstand des Teilbereiches, bei dem die Abscheidetemperatur der Vorderseite des Substrates erhöht wird, beträgt 130 mm besonders bevorzugt 147 mm gemessen vom Zentrum des Substrates.

Besonders bevorzugt beträgt der maximale Abstand des Teilbereiches, bei dem die Abscheidetemperatur der Vorderseite des Substrates erhöht wird, 5 mm von einer Orientierungsmarkierung.

## Patentansprüche

1. Verfahren zum Abscheiden einer epitaktischen Schicht auf einer Vorderseite von Substraten, umfassend
das Erhitzen eines ersten Substrats auf eine Abscheidetemperatur mittels einer ersten Wärmequelle mittels Wärmestrahlung, die zu der Vorderseite des ersten Substrats gerichtet ist,
das Erhöhen der Abscheidetemperatur auf Teilbereichen der Vorderseite des ersten Substrats unter Verwendung eines ersten Intensitätsprofils, das die Intensität der Wärmestrahlung aus einer zweiten Wärmequelle als Funktion des Ortes auf der Vorderseite des Substrates beschreibt,
das Abscheiden einer epitaktischen Schicht auf der Vorderseite des ersten Substrats, wobei Abscheidegas über die Vorderseite geleitet wird,
und das Abscheiden einer epitaktischen Schicht auf einer Vorderseite eines zweiten Substrates unter Verwendung eines zweiten Intensitätsprofils, **dadurch gekennzeichnet, dass**
sich das erste Intensitätsprofil vom zweiten Intensitätsprofil unterscheidet.

2. Verfahren nach Anspruch 1, **dadurch gekennzeichnet, dass** die zweite Wärmequelle eine Lichtquelle enthält, die Licht im infraroten Spektralbereich auf die Vorderseite gerichtet aussenden kann.

3. Verfahren nach einem der vorigen Ansprüche, **dadurch gekennzeichnet, dass** die Substrat aus monokristallinem Silicium besteht.

4. Verfahren nach Anspruch 3, **dadurch gekennzeichnet, dass** das Substrat die Kristallorientierung <110> aufweist.

5. Verfahren nach einem der vorigen Ansprüche, **dadurch gekennzeichnet, dass** der Durchmesser des Substrat 300 mm beträgt und der minimale Abstand des Teilbereiches, bei dem die Abscheidetemperatur der Vorderseite des Substrates erhöht wird, 130 mm vom Zentrum des Substrates beträgt.

6. Verfahren nach einem der vorigen Ansprüche, **dadurch gekennzeichnet, dass** der Durchmesser des Substrat 300 mm beträgt und der minimale Abstand des Teilbereiches, bei dem die Abscheidetemperatur der Vorderseite des Substrates erhöht wird, 147 mm vom Zentrum des Substrates beträgt.

7. Verfahren nach einem der vorigen Ansprüche, **dadurch gekennzeichnet, dass** der maximale Abstand des Teilbereiches, bei dem die Abscheidetemperatur der Vorderseite des Substrates erhöht wird, 5 mm von einer Orientierungsmarkierung beträgt.
